# FASCICULE DE BREVET EUROPEEN

(11) **EP 4 000 090 B1**
(45) Date de publication et mention de la délivrance du brevet: **15.03.2023**
(21) Numéro de dépôt: 20751609.7
(22) Date de dépôt: 13.07.2020
(51) Int. Cl.: H01L 21/762

(54) **PROCÉDÉ DE COLLAGE HYDROPHILE DE SUBSTRATS**
VERFAHREN ZUM HYDROPHILEN ZUSAMMENFÜGEN VON SUBSTRATEN
PROCESS FOR HYDROPHILICALLY BONDING SUBSTRATES

(30) Priorité: 15.07.2019 FR 1907964
(43) Date de publication de la demande: 25.05.2022
(73) Titulaire: SOITEC, 38190 Bernin (FR); Commissariat à l'Energie Atomique et aux Energies Alternatives, 75015 Paris (FR)
(72) Inventeur: LARREY, Vincent, 38054 GRENOBLE CEDEX 09 (FR); RIEUTORD, François, 38054 GRENOBLE CEDEX 09 (FR); HARTMANN, Jean-Michel, 38054 GRENOBLE CEDEX 09 (FR); FOURNEL, Frank, 38054 GRENOBLE CEDEX 09 (FR); LANDRU, Didier, 38190 LE CHAMP-PRES-FROGES (FR); KONONCHUCK, Oleg, 38570 THEYS (FR); ECARNOT, Ludovic, 38000 GRENOBLE (FR)
(74) Mandataire: Regimbeau
(86) Numéro de dépôt international: PCT/FR2020/051260
(87) Numéro de publication internationale: WO 2021/009459

(56) Documents cités:
- FR-A1- 2 810 448
- US-A1- 2008 153 313
- FUJIMO S ET AL: "SILICON WAFER DIRECT BONDING THROUGH THE AMORPHOUS LAYER", JAPANESE JOURNAL OF APPLIED PHYSICS, JAPAN SOCIETY OF APPLIED PHYSICS, JP, vol. 34, no. 10B, PART 02, 15 octobre 1995 (1995-10-15), pages L1322-L1324, XP000702224, ISSN: 0021-4922, DOI: 10.1143/JJAP.34.L1322

## Description

### Domaine technique

L'invention concerne un procédé de collage hydrophile de substrats pour applications en microélectronique, optoélectronique ou optique.

### Etat de la technique

Il est connu de coller des substrats, notamment des substrats semi-conducteurs, afin de former des structures adaptées à la formation de dispositifs pour la microélectronique, l'optoélectronique ou l'optique.

Par exemple, les structures de type semi-conducteur sur isolant comprennent successivement un substrat support, une couche électriquement isolante et une couche mince semi-conductrice, dite couche active. Lorsque la couche active est en silicium, la structure est dite « silicium sur isolant » (SOI, acronyme du terme anglo-saxon « Silicon On Insulator »). La couche électriquement isolante est généralement une couche d'oxyde de silicium et est souvent dite « couche d'oxyde enterrée » (BOX, acronyme du terme anglo-saxon Buried OXide »).

Un procédé particulièrement avantageux pour former de telles structures est le procédé Smart Cut ^{™}. Ce procédé comprend typiquement les étapes suivantes :
- la fourniture du substrat support ;
- la fourniture d'un substrat donneur de silicium, recouvert d'une couche d'oxyde de silicium formée par oxydation thermique ;
- l'implantation d'espèces ioniques, telles que de l'hydrogène et/ou de l'hélium, dans le substrat donneur au travers de la couche d'oxyde de silicium, de sorte à former une zone de fragilisation délimitant la couche mince à transférer ;
- le collage du substrat donneur sur le substrat support, la couche d'oxyde de silicium se trouvant à l'interface de collage ;
- la fracture du substrat donneur le long de la zone de fragilisation et le détachement du reliquat du substrat donneur de sorte à transférer la couche mince de silicium sur le substrat donneur.

De préférence, le collage est de type hydrophile, c'est-à-dire que l'adhésion entre le substrat donneur et le substrat support se fait par l'intermédiaire de molécules d'eau présentes à l'interface de collage. L'eau est éliminée ultérieurement par la mise en oeuvre d'un traitement thermique.

Pour assurer un collage de bonne qualité, les surfaces en contact du substrat support et du substrat donneur doivent présenter une très faible rugosité. Avant le collage, les substrats subissent donc généralement un traitement visant à obtenir la rugosité souhaitée.

Cependant, même si les surfaces présentent une rugosité adéquate, du fait de la rigidité et la dureté importante des substrats, leur mise en contact va toujours s'effectuer sur quelques aspérités.

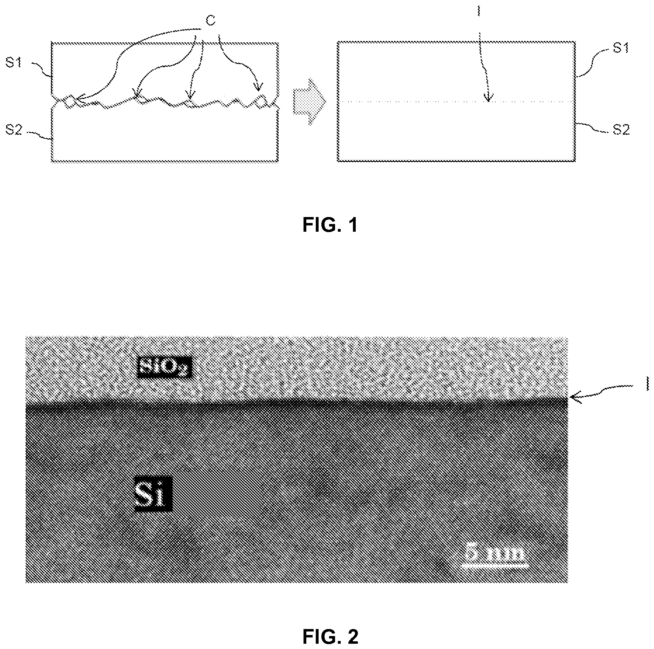

Comme on peut le voir sur la partie gauche de la figure 1, les aspérités présentes à la surface des substrats S1 et S2 engendrent des cavités C à l'interface entre les deux substrats ; l'interface de collage n'est donc pas totalement fermée. Cependant, lorsque l'on applique un traitement thermique à haute température, la surface de contact croît jusqu'à écraser les aspérités, ce qui conduit à supprimer les cavités ; l'interface de collage I est alors fermée (partie droite de la figure 1).

La figure 2 est une image en coupe au microscope électronique à transmission à haute résolution (HRTEM) d'une interface de collage I entre une couche d'oxyde de silicium (SiO₂) et un substrat de silicium (Si) à l'issue d'un tel traitement thermique. L'interface I est continue et ne présente aucune cavité, de sorte qu'elle est parfaitement fermée. Cependant, une telle fermeture de l'interface de collage ne peut être obtenue qu'au prix d'un budget thermique important. Ainsi, pour un collage entre deux couches d'oxyde thermique, la température à appliquer est d'au moins 1200°C pendant plusieurs heures. Pour un collage entre une couche d'oxyde thermique et un substrat de silicium (éventuellement recouvert d'un oxyde natif), la température à appliquer est de 1100°C pendant 2 heures ; cette température peut être réduite à 1050°C pendant 2 heures lorsque l'on applique au préalable un traitement plasma à la couche d'oxyde.

De tels traitements thermiques à haute température sont généralement très coûteux car les matériaux semi-conducteurs s'endommagent très facilement à haute température. Ils doivent donc être réalisés avec des montées en température lentes afin de ne pas risquer de déformer les substrats, ce qui occasionne des temps de traitement longs, ou bien dans des conditions de chauffe extrêmement contrôlées, ce qui nécessite des équipements complexes. Par ailleurs, le traitement thermique de fermeture de l'interface de collage est généralement la seule étape du procédé de fabrication de la structure qui nécessite une température aussi élevée.

Il serait donc souhaitable de minimiser la température du traitement thermique de fermeture de l'interface, tout en garantissant la fermeture de cette interface.

En effet, un défaut de fermeture de l'interface peut être extrêmement dommageable à l'intégrité et aux performances de la structure collée.

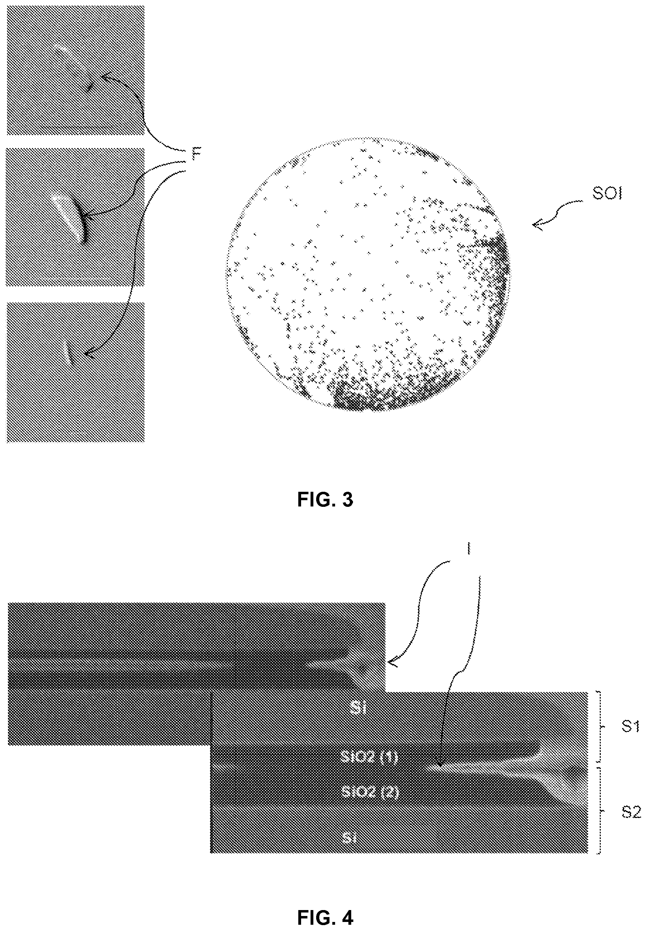

Une première conséquence d'une fermeture imparfaite de l'interface est un décollement localisé, notamment sur les bords de la structure collée. Les zones décollées sur le bord des plaques viennent se redéposer localement sur la surface du substrat, créant des zones impropres à la fabrication ultérieure de dispositifs électroniques. Ces défauts sont dénommées « flakes » selon la terminologie anglo-saxonne. La figure 3 présente ainsi une image en vue de dessus de la défectuosité d'une structure SOI liée à une fermeture incomplète de l'interface de collage, les défauts étant identifiés par les points sombres.

Les trois inserts situés dans la partie gauche de la figure 3 sont des images au microscope électronique à balayage (SEM) de trois défauts F de type « flakes » de différentes formes et dimensions.

Une seconde conséquence d'une fermeture imparfaite de l'interface est que les cavités présentes au niveau de l'interface, notamment sur les bords de la structure, sont des zones susceptibles d'être attaquées de manière privilégiée par un agent de gravure chimique. L'agent de gravure peut en effet s'insérer dans l'interface par ces cavités et graver préférentiellement les matériaux présents à l'interface. La figure 4 présente ainsi une vue en coupe d'une interface entre deux couches d'oxyde de silicium (SiO₂ (1), SiO₂ (2)) appartenant chacune à un substrat S1, S2. L'image de droite est une vue grossie de l'image de gauche. Sur ces images, la partie plus claire au niveau de l'interface I correspond à l'oxyde de silicium qui a été gravé.

L'ajout de couches métalliques (par exemple cuivre, tungstène) à l'interface de collage ou bien de dépôts de polymères permet d'atteindre des températures de fermeture de l'interface basses, typiquement inférieures à 500°C. Cependant, les matériaux métalliques, étant électriquement conducteurs ou générateurs d'impuretés dans les substrats semi-conducteurs, sont incompatibles avec un grand nombre d'applications microélectroniques. Par ailleurs, les polymères sont instables aux températures de fabrication des circuits.

Il existe par ailleurs des techniques de collage non hydrophile, par exemple le collage sous ultra-vide, la surface des substrats en contact étant préalablement activée mécaniquement par un bombardement ionique. La fermeture de l'interface intervient dans ce cas à température ambiante. Cette technique est dénommée SAB, acronyme du terme anglo-saxon « Surface Activated Bonding ». Cependant, cette technique n'est pas compatible avec la présence d'un oxyde à l'interface de collage.

US 2008/153313 A1, FR 2 810 448 A1 et Fujimo et al.: "Silicon wafer direct bonding through the amorphous layer",Japanese Journal of Applied Physics, vol. 34, no. 10B, part 02, pages L1322-L1324, DOI: 10.1143/JJAP.34.L1322 divulguent des procédés de collage hydrophile de deux substrats connus de l'art antérieur.

### Brève description de l'invention

Un but de l'invention est donc de concevoir un procédé de collage hydrophile de deux substrats dans lequel l'interface de collage est fermée au moyen d'un traitement thermique à température plus basse que dans les procédés existants.

A cet effet, l'invention propose un procédé de collage hydrophile d'un premier substrat sur un second substrat, comprenant :
- la mise en contact du premier substrat et du second substrat, de sorte à former une interface de collage entre une surface principale du premier substrat et une surface principale du second substrat,
- l'application d'un traitement thermique adapté pour fermer ladite interface de collage, ledit procédé étant caractérisé en ce qu'il comprend, avant l'étape de mise en contact, le dépôt, sur la surface principale du premier et/ou du second substrat, d'une couche de collage en un matériau non métallique perméable au dihydrogène et présentant, à la température du traitement thermique, une limite élastique inférieure à celle d'au moins un des matériaux du premier substrat et du second substrat situés à l'interface de collage, ladite couche présentant une épaisseur comprise entre 1 et 6 nm.

Par ailleurs, le traitement thermique de collage est mis en oeuvre à une température inférieure ou égale à 900°C, de préférence inférieure ou égale à 600°C.

La limite élastique (« yield strength » selon la terminologie anglo-saxonne) est la contrainte à partir de laquelle un matériau ductile considéré se déforme plastiquement. La limite élastique est une grandeur usuelle des matériaux, et sa variation en fonction de la température peut être déterminée, de sorte qu'une comparaison de la limite élastique de deux matériaux à une température donnée est à la portée de l'homme du métier.

Ainsi, par exemple, à une température de l'ordre de 900°C, le silicium amorphe présente une limite élastique inférieure à celle du silicium cristallin ou poly-cristallin (généralement recouvert d'un oxyde natif) et de l'oxyde de silicium. Il en va de même pour le germanium amorphe.

La limite élastique traduit la capacité des matériaux présents à l'interface de collage à se déformer plastiquement à la température de mise en oeuvre du traitement thermique.

La couche de collage est donc plus apte à se conformer à la surface principale du substrat opposé de sorte à fermer l'interface et ce, à une température plus basse.

Par ailleurs, cette très fine couche de collage est compatible avec le processus chimique de collage hydrophile. En effet, ladite couche est suffisamment poreuse pour permettre le passage du dihydrogène produit par la réaction de l'eau avec le silicium du second substrat vers la couche d'oxyde de silicium, ce qui évite les problèmes de défectivité rencontrés lors d'un collage silicium sur silicium.

Selon d'autres caractéristiques avantageuses, considérées seules ou en combinaison lorsque cela est techniquement pertinent :
- le premier et le second substrat sont des substrats semi-conducteurs,
- le premier substrat comprend une couche superficielle d'oxyde de silicium autre qu'un oxyde natif, et la couche de collage est déposée sur ladite couche d'oxyde de silicium ;
- la couche superficielle d'oxyde de silicium est formée par oxydation thermique du premier substrat ;
- le second substrat comprend une couche superficielle d'oxyde de silicium autre qu'un oxyde natif, et une couche de collage est également déposée sur ladite couche d'oxyde de silicium ;
- après l'application du traitement thermique de fermeture de l'interface de collage, le procédé comprend une étape d'amincissement du premier substrat de sorte à transférer une couche mince de silicium du premier substrat sur le second substrat ;
- entre le dépôt de la couche de collage et la mise en contact du premier substrat et du second substrat, le procédé comprend la formation d'une couche superficielle d'oxyde de silicium sur le premier substrat et l'implantation d'espèces ioniques dans le premier substrat au travers de la couche d'oxyde de silicium de sorte à former une zone de fragilisation délimitant la couche semi-conductrice à transférer ;
- entre le dépôt de la couche de collage et la mise en contact du premier et du second substrat, le procédé comprend la mise en oeuvre d'un traitement hydrophile de la surface principale desdits substrats, l'application d'eau sur la surface principale desdits substrats afin de former un film d'eau sur ladite surface principale ;
- avant le dépôt de la couche de collage, le procédé comprend une étape de nettoyage de la surface principale sur laquelle ladite couche doit être déposée par une solution oxydante ;
- le second substrat est un substrat de silicium, ledit substrat étant recouvert d'une couche d'oxyde de silicium natif ;
- lors de la mise en oeuvre du traitement thermique de fermeture de l'interface de collage, le procédé comprend une oxydation d'une portion superficielle du silicium du second substrat au travers de la couche d'oxyde natif ;
- le matériau de la couche de collage est choisi parmi : le silicium amorphe et le germanium amorphe ;
- le matériau de la couche de collage est du silicium amorphe et la couche de silicium amorphe est formée dans un bâti d'épitaxie à une température inférieure à 550°C ;
- la couche de silicium amorphe est formée à partir d'un précurseur choisi parmi : le disilane (Si₂H₆), le silane (SiH₄) ou un précurseur liquide de formule SiₙH₂ₙ₊₂ où n est un entier supérieur à 2 ;
- lors de la mise en oeuvre du traitement thermique de fermeture de l'interface de collage, le procédé comprend une oxydation d'au moins une partie de la couche de collage ;
- l'épaisseur de la couche de collage est choisie pour que la totalité de ladite couche soit oxydée au cours du traitement thermique de fermeture de l'interface de collage.

### Brève description des dessins

D'autres caractéristiques et avantages de l'invention ressortiront de la description détaillée qui va suivre, en référence aux dessins annexés sur lesquels :
- la figure 1 illustre de manière schématique la fermeture d'une interface de collage ;
- la figure 2 est une image en coupe au microscope électronique à transmission à haute résolution (HRTEM) d'une interface de collage oxyde de silicium - silicium totalement fermée ;
- la figure 3 présente une image d'un substrat SOI présentant des défauts de type « flakes » et des images au microscope électronique à balayage (SEM) de tels défauts ;
- la figure 4 est une image en coupe d'une interface de collage imparfaitement fermée et ayant subi une attaque chimique préférentielle ;
- la figure 5A est un schéma en coupe d'une étape préalable à la mise en contact des substrats dans un premier mode de réalisation du procédé selon l'invention ;
- la figure 5B est un schéma en coupe des substrats de la figure 5A après mise en contact, avant la fermeture de l'interface de collage ;
- la figure 5C est un schéma en coupe des substrats de la figure 5B avec l'interface de collage fermée après la mise en oeuvre du traitement thermique ;
- la figure 6A présente des images en vue de dessus de structures collées avec une couche de silicium amorphe dont l'épaisseur est supérieure ou égale à 8 nm ;
- la figure 6B présente une image en vue de dessus d'une structure collée avec une couche de silicium amorphe dont l'épaisseur est comprise entre 2,5 et 6 nm ;
- la figure 7 est une image en coupe au microscope électronique en transmission (TEM) de l'interface de collage entre un substrat de silicium et une couche d'oxyde de silicium sur laquelle une couche de silicium amorphe de 6 nm d'épaisseur avait été déposée, après la mise en oeuvre d'un traitement thermique à 500°C ;
- la figure 8A est un schéma en coupe d'une étape préalable à la mise en contact des substrats dans un second mode de réalisation du procédé selon l'invention ;
- la figure 8B est un schéma en coupe des substrats de la figure 8A après mise en contact, avant la fermeture de l'interface de collage ;
- la figure 8C est un schéma en coupe des substrats de la figure 8B avec l'interface de collage fermée après la mise en oeuvre du traitement thermique ;
- la figure 9 est un graphe représentant le ratio R (sans unité) entre la vitesse de gravure horizontale et la vitesse de gravure verticale en fonction de la température T (°C) de fermeture de l'interface, pour un procédé de collage standard (a) et un procédé de collage selon l'invention (b).

Pour des raisons de lisibilité des figures, les épaisseurs des différentes couches schématisées n'ont pas nécessairement été représentées à l'échelle.

### Description détaillée de modes de réalisation

### Présentation générale du procédé

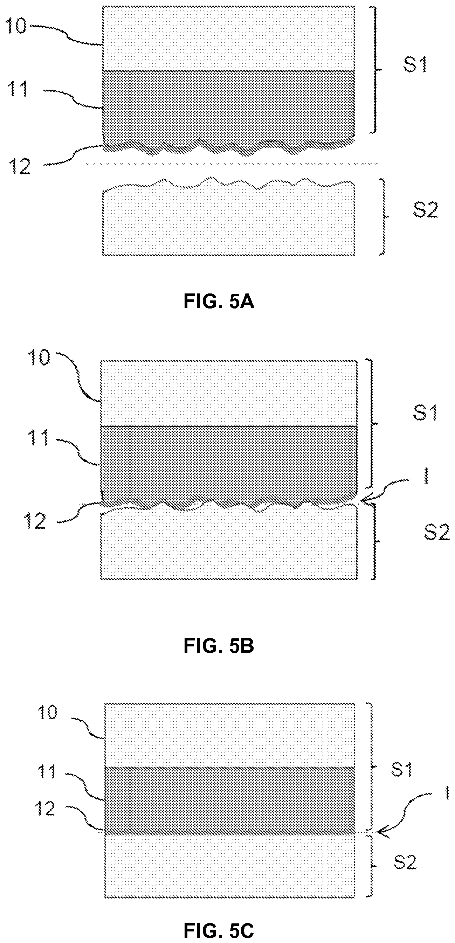

Les figures 5A à 5C illustrent des étapes successives d'un procédé selon un premier mode de réalisation de l'invention.

En référence à la figure 5A, on fournit un premier substrat S1 et un second substrat S2 à coller le long d'une de leurs faces principales.

Selon un mode de réalisation, le premier et le second substrat sont des substrats semi-conducteurs, c'est-à-dire comprenant au moins une couche d'un matériau semi-conducteur, tel que du silicium. Les substrats peuvent éventuellement comprendre d'autres matériaux, par exemple une couche d'un matériau électriquement isolant, tel que de l'oxyde de silicium (SiO₂).

D'une manière générale, l'invention s'applique à tout substrat compatible avec un collage hydrophile. Certains substrats sont naturellement hydrophiles ; ceux qui ne le sont pas peuvent subir un traitement pour rendre leur surface hydrophile, comme exposé plus bas. Avant la mise en contact des substrats, on dépose une couche 12 d'un matériau qui présente à la fois une faible limite élastique et une certaine perméabilité au dihydrogène sur l'un et/ou l'autre des substrats S1, S2 à basse température (entre 200°c et 600°C). Dans l'exemple illustré, la couche de collage est déposée sur le substrat S1 mais, de manière alternative ou supplémentaire, elle pourrait être déposée aussi sur le substrat S2. En pratique, la couche de collage est de préférence déposée sur le substrat dont le matériau présent à l'interface de collage présente la limite élastique la plus élevée à la température de mise en oeuvre du traitement thermique de fermeture de l'interface. Ainsi, on minimise l'effet négatif d'un matériau à limite élastique élevée. Par exemple, dans le cas d'un collage oxyde / silicium, la couche de collage est déposée de préférence sur le substrat comprenant la couche d'oxyde.

L'épaisseur de la couche de collage est choisie suffisamment fine pour procurer une certaine porosité à ladite couche. Selon l'invention, ladite épaisseur est comprise entre 1 et 6 nm.

Selon un mode de réalisation avantageux, notamment lorsque les matériaux présents sur la face principale des substrats S1, S2 sont du silicium ou de l'oxyde de silicium, le matériau de la couche de collage est du silicium amorphe ou du germanium amorphe. Le silicium amorphe représente en particulier un choix intéressant pour la couche de collage car, à haute température (typiquement supérieure à 900°C), le silicium amorphe présente une limite élastique inférieure à celle du silicium cristallin et de l'oxyde de silicium. De manière alternative, le germanium amorphe est également adapté pour cette application car il présente une limite élastique inférieure à celle de ces matériaux.

On exclut en revanche les matériaux métalliques pour la couche de collage, notamment en raison des inconvénients indiqués en introduction.

La figure 5B illustre la mise en contact des substrats S1 et S2 par l'intermédiaire de la couche de collage 12.

Le collage hydrophile nécessite généralement la mise en oeuvre d'un traitement hydrophile des faces des substrats, par exemple un nettoyage de type SC1 puis un rinçage à l'eau. A l'issue de cette étape, les surfaces des substrats sont recouvertes d'une fine pellicule d'eau (de l'ordre de 2 ou 3 monocouches) liée à la face principale par des liaisons hydrogène.

Avant la mise en oeuvre du traitement thermique de fermeture de l'interface, les faces principales des substrats S1 et S2, bien que lisses, présentent des aspérités au niveau desquelles se produit le contact entre les substrats. Des cavités s'étendent entre ces aspérités, de sorte que l'interface I n'est pas fermée.

La figure 5C illustre la structure à l'issue du traitement thermique de fermeture de l'interface de collage. Le traitement thermique dure quelques heures, de préférence environ 2 heures, et comprend une montée en température relativement lente afin de ne pas endommager les substrats. La température du traitement thermique peut être définie par l'homme du métier, par exemple à partir de tests de fermeture de l'interface de plusieurs structures identiques traitées à des températures différentes. On sélectionne de préférence la température la plus basse parmi les températures qui conduisent à une fermeture complète de l'interface de collage.

Sous l'effet de la température et de l'attraction mutuelle des surfaces en contact, les aspérités de la couche de collage s'écrasent, ce qui conduit à la suppression des cavités interstitielles et à la fermeture de l'interface I.

Outre ce phénomène mécanique, une réaction chimique se produit entre l'eau et le matériau semi-conducteur présent à l'interface de collage pendant le traitement thermique, conduisant au dégagement de dihydrogène.

Dans le cas d'un collage hydrophile oxyde / silicium, la réaction chimique s'écrit :

2 H₂O + Si → SiO₂ + 2 H₂

En d'autres termes, l'eau présente à l'interface de collage traverse l'oxyde natif présent sur le silicium et oxyde ledit silicium. Ce phénomène se produit dès 150°C et conduit au dégagement de dihydrogène, qui diffuse dans la couche d'oxyde située de l'autre côté de l'interface de collage et y est stocké. Si ladite couche d'oxyde est trop fine ou qu'il existe une barrière de diffusion entre l'interface de collage et la couche d'oxyde, le dihydrogène rouvre l'interface de collage en formant des bulles. On pourra se référer à cet égard à la publication [Vincent et al].

On pouvait donc craindre que la couche de collage ne constitue une telle barrière et ne conduise à une défectivité importante de la structure collée.

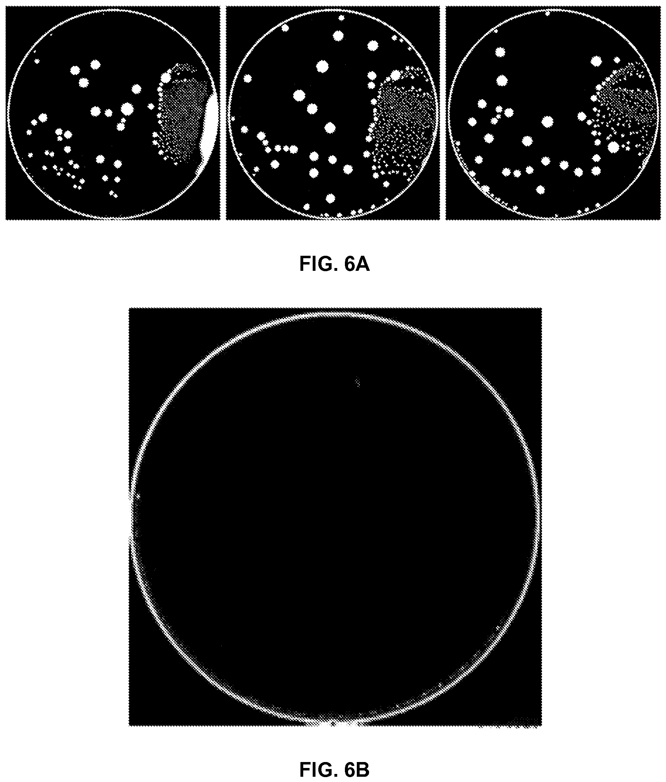

La figure 6A présente ainsi des images en vue de dessus de la couche d'oxyde enterrée provenant de structures collées avec une couche de silicium amorphe dont l'épaisseur est supérieure ou égale à 8 nm, à savoir, de gauche à droite : 8 nm, 14 nm et 28 nm. Les taches blanches représentent les bulles de dihydrogène qui se sont formées à l'interface de collage. On constate pour ces trois structures une défectivité importante.

En revanche, de manière surprenante, pour une structure collée avec une couche de silicium amorphe d'épaisseur comprise entre 1 et 6 nm, une telle défectivité n'est pas générée. La figure 6B présente ainsi une image en vue de dessus de la couche d'oxyde enterrée provenant d'une structure collée avec une couche de silicium amorphe dont l'épaisseur est comprise entre 2,5 et 6 nm ; l'absence des taches blanches observées sur la figure 6A montre l'absence de bulles de dihydrogène. On peut donc considérer que la couche de silicium amorphe est alors suffisamment fine pour permettre la diffusion du dihydrogène vers la couche d'oxyde enterrée, assurant ainsi un collage de bonne qualité.

### Exemple de mise en oeuvre

Selon une application particulière du procédé décrit en référence aux figures 5A à 5C, le substrat S1 est un substrat de silicium 10 recouvert d'une couche 11 d'oxyde de silicium. Ladite couche d'oxyde de silicium est de préférence formée par oxydation thermique du silicium. Le substrat S2 est un substrat de silicium, qui présente typiquement une couche d'oxyde de silicium natif (non représentée) sur sa surface.

On rappelle qu'une couche d'oxyde natif diffère d'une couche d'oxyde thermique par son épaisseur (la couche d'oxyde natif étant beaucoup plus fine que la couche d'oxyde thermique), ainsi que par sa stoechiométrie. La couche d'oxyde natif est présente naturellement à la surface du substrat, et n'est pas destinée à remplir une fonction particulière. En revanche, la couche d'oxyde thermique est en général destinée à remplir une fonction d'isolation électrique au sein de la structure obtenue par collage des deux substrats. Ainsi, dans le cas d'un SOI, la couche d'oxyde thermique est destinée à former la couche d'oxyde enterrée (BOX) du SOI.

Le dépôt d'une couche de collage 12 constituée de silicium amorphe peut être effectué comme suit.

La surface du substrat destinée à recevoir la couche de silicium amorphe est nettoyée au moyen d'une solution oxydante, par exemple du type O₃/HF/O₃ ou O₃/HF/SC1.

Avant de garantir les caractères amorphe et lisse du silicium amorphe, le substrat est placé dans un bâti d'épitaxie porté à une température relativement basse. Selon un mode de réalisation, le précurseur utilisé est le disilane (Si₂H₆) ; la température optimale de dépôt est comprise entre 475 et 550°C. La vitesse de croissance est alors de 5 à 10 nm/mn. Selon un autre mode de réalisation, le précurseur utilisé est le silane (SiH₄) ; la vitesse de croissance est alors plus faible. Selon d'autres modes de réalisation, le précurseur est un précurseur liquide de formule SiₙH₂ₙ₊₂ où n est un entier supérieur à 2, nécessitant l'utilisation d'un barboteur ; la température de dépôt est alors de l'ordre de 425 à 450°C.

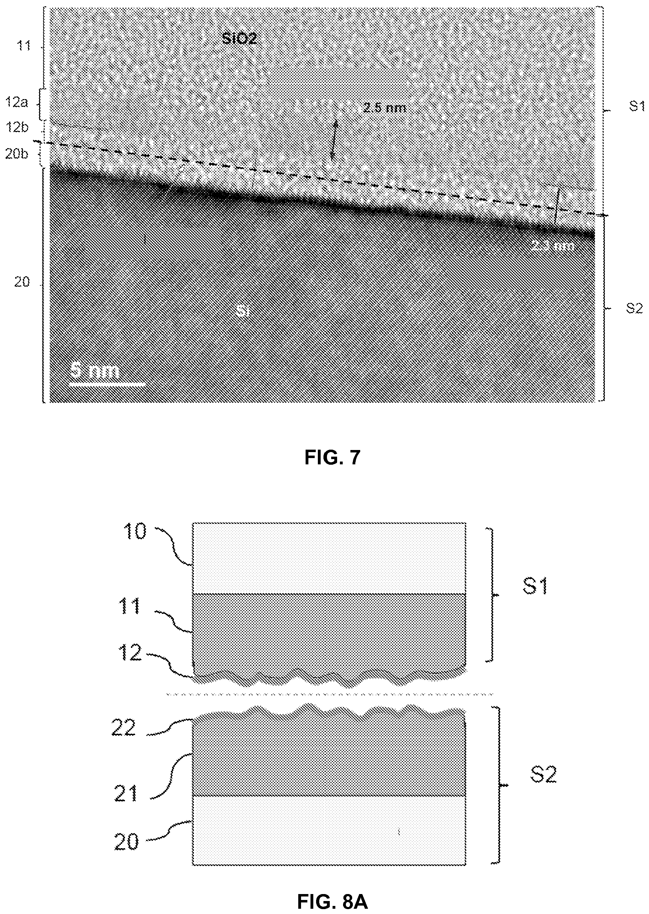

La figure 7 est une image en coupe au microscope électronique en transmission (TEM) de l'interface de collage entre un substrat S2 comprenant un substrat de silicium 20 recouvert d'une couche 20b d'oxyde de silicium natif et un substrat S1 comprenant un substrat de silicium (non visible) recouvert d'une couche 11 d'oxyde de silicium sur laquelle une couche de silicium amorphe de 6 nm d'épaisseur a été déposée, après la mise en oeuvre d'un traitement thermique à 500°C.

La couche de silicium amorphe a été partiellement convertie en oxyde de silicium par réaction avec l'eau de collage au niveau de sa surface formant l'interface de collage I. On désigne par 12a la partie résiduelle de silicium amorphe et par 12b la partie de la couche de collage convertie en oxyde de silicium. Cette partie 12b est combinée avec la couche 20b d'oxyde de silicium natif du substrat S2 pour former une couche d'oxyde de silicium qui s'étend de part et d'autre de l'interface de collage I.

On peut éventuellement mettre à profit ce phénomène pour transformer l'intégralité de la couche de silicium amorphe en oxyde de silicium au cours du traitement thermique de fermeture de l'interface de collage. On choisit à cet effet l'épaisseur de la couche de silicium amorphe déposée suffisamment faible pour que la réaction avec l'eau de collage la consomme entièrement.

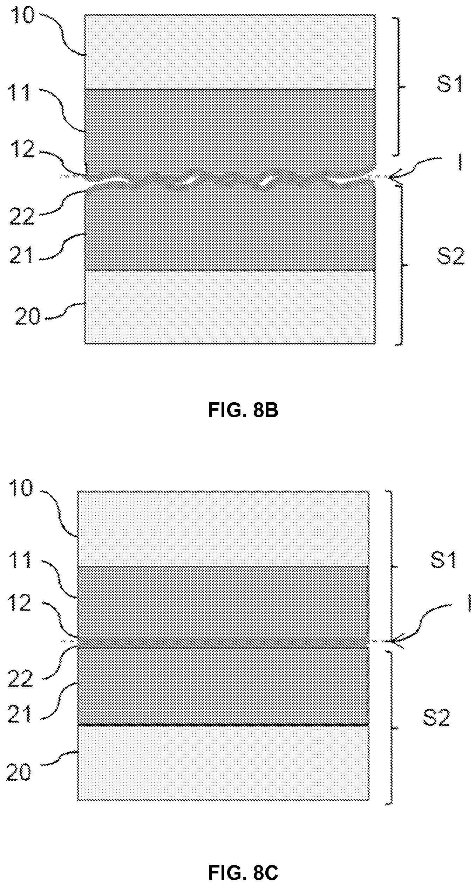

Les figures 8A à 8C illustrent des étapes successives d'un procédé selon un second mode de réalisation de l'invention.

Les étapes illustrées aux figures 8A à 8C sont de même nature que les étapes décrites en référence aux figures 5A à 5C, la différence entre les deux modes de réalisation du procédé étant que, dans ce second mode de réalisation, la couche de collage est déposée sur chacun des substrats S1 et S2. Les étapes communes aux deux procédés ne sont donc pas décrites à nouveau.

Dans le cas des figures 8A à 8C, le substrat S1 comprend une couche 10 (par exemple de silicium) recouverte d'une couche 11 d'oxyde de silicium. De même, le substrat S2 comprend une couche 20 (par exemple de silicium) recouverte d'une couche 21 d'oxyde de silicium. Lesdites couches d'oxyde de silicium 11, 21 peuvent être formées par oxydation thermique du silicium.

Il s'agit donc dans ce cas d'un collage oxyde / oxyde. Un tel collage permet d'utiliser le collage hydrophile, qui est standard dans l'industrie de la microélectronique, pour assembler n'importe quels matériaux, même incompatibles avec ce collage (il suffit en effet de les recouvrir d'une fine couche d'oxyde pour se placer dans les conditions d'un collage hydrophile). Pour la fabrication d'une structure SOI, le collage oxyde/oxyde permet d'obtenir une couche d'oxyde enterré épaisse ou d'encapsuler l'interface de collage dans l'oxyde lorsqu'elle est susceptible d'interagir avec le silicium.

### Application au procédé Smart Cut^{™}

Ce procédé de collage trouve avantageusement mais de manière non limitative une application dans le procédé Smart Cut^{™} pour la fabrication d'une structure SOI.

Par application de l'invention, lors de la mise en oeuvre de ce procédé, on dépose une couche de silicium amorphe sur la couche d'oxyde du substrat donneur (correspondant au substrat S1 sur les figures 5A à 5C), sur une épaisseur de 1 à 6 nm, et l'on met ensuite en oeuvre l'implantation ionique de fragilisation du substrat donneur.

Le silicium amorphe présentant une limite élastique plus faible que celle du silicium et de l'oxyde de silicium, il permet de mettre en oeuvre le traitement thermique de fermeture de l'interface de collage à une température de l'ordre de 900°C pendant 2 heures, alors que, selon le procédé Smart Cut^{™} standard, la température à appliquer pour obtenir une fermeture complète est de 1100°C pendant 2 heures, voire 1050°C pendant 2 heures si la couche d'oxyde a été activée par plasma préalablement à la mise en contact des substrats.

De manière alternative au procédé Smart Cut^{™}, il est possible de transférer une couche mince semi-conductrice par un autre procédé d'amincissement, tel qu'une gravure du substrat donneur par sa face opposée à l'interface de collage.

### Résultats expérimentaux

La fermeture de l'interface de collage peut également être évaluée au moyen du ratio entre la vitesse de gravure horizontale (c'est-à-dire dans le plan de l'interface de collage) et la vitesse de gravure verticale (c'est-à-dire dans la direction perpendiculaire à l'interface de collage) d'une structure collée exposée à une solution de gravure. Lorsque l'interface de collage est bien fermée, ce ratio est proche de 1, ce qui traduit le fait que la solution de gravure grave de manière homogène l'ensemble de la structure. En revanche, lorsque l'interface de collage n'est pas fermée, la solution de gravure s'insère dans les cavités de l'interface de collage, procurant ainsi une gravure plus rapide de l'interface que du reste de la structure. Le ratio est alors supérieur à 1.

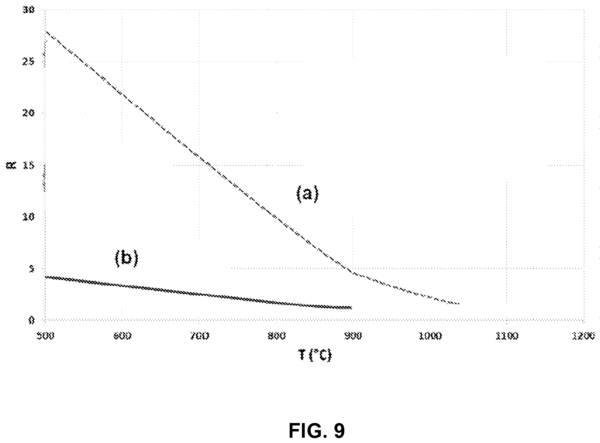

La figure 9 illustre ledit ratio R en fonction de la température T de fermeture de l'interface, pour un procédé de collage standard (a) et un procédé de collage selon l'invention (b). Dans le procédé de collage standard, plusieurs structures ont été formées par collage hydrophile d'un premier substrat comprenant un substrat de silicium recouvert d'une couche d'oxyde de silicium sur un second substrat de silicium. Les matériaux présents à l'interface de collage étaient donc l'oxyde de silicium du premier substrat (préalablement activé par plasma) et le silicium du second substrat. Chaque structure collée a été soumise à un traitement thermique à une température différente, entre 500 et 1050°C. Après le traitement thermique, chaque structure collée a été exposée à une solution de gravure composée d'acide fluorhydrique (HF) dilué à 10% et la vitesse de gravure a été mesurée tant dans la direction verticale que dans la direction horizontale.

Dans le procédé de collage selon l'invention, plusieurs structures ont été formées par collage hydrophile d'un premier substrat S1 comprenant un substrat de silicium recouvert d'une couche d'oxyde de silicium sur laquelle avait été déposée une couche de silicium amorphe de 1 à 6 nm d'épaisseur sur un second substrat de silicium. Les matériaux présents à l'interface de collage étaient donc le silicium amorphe déposé sur le premier substrat et le silicium du second substrat. Chaque structure collée a été soumise à un traitement thermique à une température différente, entre 500 et 900°C. Après le traitement thermique, chaque structure collée a été exposée à la solution de gravure susmentionnée et la vitesse de gravure a été mesurée tant dans la direction verticale que dans la direction horizontale.

La comparaison des courbes (a) et (b) montre que, dans le cas du collage standard, l'interface de collage n'est fermée (R environ égal à 1) qu'avec un traitement thermique à 1050°C, toute diminution de la température dudit traitement thermique se traduisant par une augmentation significative du ratio R, c'est-à-dire par une dégradation de la fermeture de l'interface de collage. En revanche, avec le procédé de collage selon l'invention, l'interface est fermée dès 900°C ; par ailleurs, la pente de la courbe (b) est beaucoup moins forte que celle de la courbe (a), de sorte qu'une diminution de la température du traitement thermique a un effet moins néfaste sur la qualité de la fermeture de l'interface. En particulier, une température de l'ordre de 600°C permet d'obtenir une fermeture presque complète.

### Références

[Vincent et al]: A model of interface defect formation in silicon wafer bonding, S. Vincent et al, Applied Physics Letters 94, 101914 (2009)

## Revendications

1. Procédé de collage hydrophile d'un premier substrat (S1) sur un second substrat (S2), comprenant :
- la mise en contact du premier substrat (S1) et du second substrat (S2), de sorte à former une interface (I) de collage entre une surface principale du premier substrat et une surface principale du second substrat,
- l'application d'un traitement thermique adapté pour fermer ladite interface de collage, ledit procédé étant **caractérisé en ce qu'**il comprend, avant l'étape de mise en contact, le dépôt, sur la surface principale du premier et/ou du second substrat, d'une couche de collage (12, 22) en un matériau non métallique perméable au dihydrogène et présentant, à la température du traitement thermique, une limite élastique inférieure à celle d'au moins un des matériaux du premier substrat (S1) et du second substrat (S2) situés à l'interface de collage, ladite couche présentant une épaisseur comprise entre 1 et 6 nm, et **en ce que** le traitement thermique est mis en oeuvre à une température inférieure ou égale à 900°C, de préférence inférieure ou égale à 600°C.

2. Procédé selon la revendication 1, dans lequel le premier substrat (S1) comprend une couche superficielle (11) d'oxyde de silicium autre qu'un oxyde natif, et la couche de collage est déposée sur ladite couche d'oxyde de silicium.

3. Procédé selon la revendication 2, dans lequel la couche superficielle d'oxyde de silicium est formée par oxydation thermique du premier substrat (S1).

4. Procédé selon l'une des revendications 2 ou 3, dans lequel le second substrat (S2) comprend une couche superficielle (21) d'oxyde de silicium autre qu'un oxyde natif, et une couche de collage est également déposée sur ladite couche d'oxyde de silicium.

5. Procédé selon l'une des revendications 1 à 4, comprenant, après l'application du traitement thermique de fermeture de l'interface de collage, une étape d'amincissement du premier substrat de sorte à transférer une couche mince du premier substrat sur le second substrat.

6. Procédé selon la revendication 5, comprenant en outre, entre le dépôt de la couche de collage et la mise en contact du premier substrat et du second substrat, la formation d'une couche superficielle d'oxyde de silicium sur le premier substrat et l'implantation d'espèces ioniques dans le premier substrat au travers de la couche d'oxyde de silicium de sorte à former une zone de fragilisation délimitant la couche semi-conductrice à transférer.

7. Procédé selon l'une des revendications 1 à 6, comprenant, entre le dépôt de la couche de collage et la mise en contact du premier et du second substrat, la mise en oeuvre d'un traitement hydrophile de la surface principale desdits substrats, l'application d'eau sur la surface principale desdits substrats afin de former un film d'eau sur ladite surface principale.

8. Procédé selon l'une des revendications 1 à 7, comprenant, avant le dépôt de la couche de collage, une étape de nettoyage de la surface principale sur laquelle ladite couche doit être déposée par une solution oxydante.

9. Procédé selon l'une des revendications 1 à 8, dans lequel le second substrat (S2) est un substrat de silicium, ledit substrat étant recouvert d'une couche (20b) d'oxyde de silicium natif.

10. Procédé selon la revendication 9, comprenant, lors de la mise en oeuvre du traitement thermique de fermeture de l'interface de collage, une oxydation d'une portion superficielle du silicium du second substrat au travers de la couche d'oxyde natif.

11. Procédé selon l'une des revendications 1 à 10, dans lequel le matériau de la couche de collage (12, 22) est choisi parmi : le silicium amorphe et le germanium amorphe.

12. Procédé selon la revendication 11, dans lequel le matériau de la couche de collage est du silicium amorphe et la couche de silicium amorphe est formée dans un bâti d'épitaxie à une température inférieure à 550°C.

13. Procédé selon la revendication 12, dans lequel la couche de silicium amorphe est formée à partir d'un précurseur choisi parmi : le disilane (Si₂H₆), le silane (SiH₄) ou un précurseur liquide de formule SiₙH₂ₙ₊₂ où n est un entier supérieur à 2.

14. Procédé selon l'une des revendications 11 à 13, comprenant, lors de la mise en oeuvre du traitement thermique de fermeture de l'interface de collage, une oxydation d'au moins une partie (12b) de la couche de collage (12).

15. Procédé selon la revendication 14, dans lequel l'épaisseur de la couche de collage (12) est choisie pour que la totalité de ladite couche soit oxydée au cours du traitement thermique de fermeture de l'interface de collage.

## Patentansprüche

1. Verfahren zum hydrophilen Bonden eines ersten Substrats (S1) auf ein zweites Substrat (S2), umfassend:
- das Inkontaktversetzen des ersten Substrats (S1) und des zweiten Substrats (S2), so dass eine Bondingschnittstelle (I) zwischen einer Hauptfläche des ersten Substrats und einer Hauptfläche des zweiten Substrats gebildet wird,
- das Anwenden einer thermischen Behandlung, die zum Schließen der Bondingschnittstelle geeignet ist, wobei das Verfahren **dadurch gekennzeichnet ist, dass** es vor dem Schritt des Inkontaktversetzens das Aufbringen auf die Hauptfläche des ersten und/oder des zweiten Substrats einer Bondingschicht (12, 22) aus einem für Dihydrogen durchlässigen nichtmetallischen Material umfasst, das bei der Temperatur der thermischen Behandlung eine Elastizitätsgrenze aufweist, die unter der von mindestens einem der Materialien des ersten Substrats (S1) und des zweiten Substrats (S2) ist, die sich an der Bondingschnittstelle befinden, wobei die Schicht eine Dicke aufweist, die zwischen 1 und 6 nm liegt, und dass die thermische Behandlung bei einer Temperatur von unter oder gleich 900 °C, vorzugsweise von unter oder gleich 600 °C, durchgeführt wird.

2. Verfahren nach Anspruch 1, wobei das erste Substrat (S1) eine oberflächliche Schicht (11) aus Siliziumoxid umfasst, das kein natives Oxid ist, und die Bondingschicht auf die Siliziumoxidschicht aufgebracht wird.

3. Verfahren nach Anspruch 2, wobei die oberflächliche Siliziumoxidschicht durch thermische Oxidation des ersten Substrats (S1) gebildet wird.

4. Verfahren nach einem der Ansprüche 2 oder 3, wobei das zweite Substrat (S2) eine Oberflächenschicht (21) aus Siliziumoxid umfasst, das kein natives Oxid ist, und eine Bondingschicht ebenfalls auf die Siliziumoxidschicht aufgebracht wird.

5. Verfahren nach einem der Ansprüche 1 bis 4, das nach der Anwendung der thermischen Verschlussbehandlung der Bondingschnittstelle einen Schritt des Verschlankens des ersten Substrats umfasst, so dass eine dünne Schicht des ersten Substrats auf das zweite Substrat übertragen wird.

6. Verfahren nach Anspruch 5, das ferner zwischen dem Aufbringen der Bondingschicht und dem Inkontaktversetzen des ersten Substrats und des zweiten Substrats das Bilden einer oberflächliche Siliziumoxidschicht auf dem ersten Substrat und das Implantieren von Ionenspezies in das erste Substrat durch die Siliziumoxidschicht hindurch umfasst, so dass eine Schwächungszone gebildet wird, die die zu übertragende halbleitende Schicht begrenzt.

7. Verfahren nach einem der Ansprüche 1 bis 6, das zwischen dem Aufbringen der Bondingschicht und dem Inkontaktversetzen des ersten und des zweiten Substrats das Durchführen einer hydrophilen Behandlung der Hauptfläche der Substrate, das Auftragen von Wasser auf die Hauptfläche der Substrate umfasst, um einen Wasserfilm auf der Hauptfläche zu bilden.

8. Verfahren nach einem der Ansprüche 1 bis 7, das vor dem Aufbringen der Bondingschicht einen Reinigungsschritt der Hauptfläche umfasst, auf die die Schicht mittels einer oxidierenden Lösung aufgebracht werden muss.

9. Verfahren nach einem der Ansprüche 1 bis 8, wobei das zweite Substrat (S2) ein Siliziumsubstrat ist, wobei das Substrat von einer Schicht (20b) aus nativem Siliziumoxid bedeckt ist.

10. Verfahren nach Anspruch 9, das bei der Durchführung der thermischen Verschlussbehandlung der Bondingschnittstelle eine Oxidation eines Oberflächenabschnitts des Siliziums des zweiten Substrats durch die native Oxidschicht hindurch umfasst.

11. Verfahren nach einem der Ansprüche 1 bis 10, wobei das Material der Bondingschicht (12, 22) aus dem amorphen Silizium und dem amorphen Germanium ausgewählt ist.

12. Verfahren nach Anspruch 11, wobei das Material der Bondingschicht amorphes Silizium ist und die amorphe Siliziumschicht in einem Epitaxiegerüst bei einer Temperatur von unter 550 °C gebildet ist.

13. Verfahren nach Anspruch 12, wobei die amorphe Siliziumschicht aus einem Vorläufer gebildet ist, der aus Disilan (Si₂H₆), Silan (SiH₄) oder einem flüssigen Vorläufer der Formel SiₙH₂ₙ₊₂ ausgewählt ist, wobei n eine Ganzzahl größer als 2 ist.

14. Verfahren nach einem der Ansprüche 11 bis 13, das bei der Durchführung der thermischen Verschlussbehandlung der Bondingschnittstelle eine Oxidation von mindestens einem Teil (12b) der Bondingschicht (12) umfasst.

15. Verfahren nach Anspruch 14, wobei die Dicke der Bondingschicht (12) gewählt ist, damit die Gesamtheit der Schicht während der thermischen Verschlussbehandlung der Bondingschnittstelle oxidiert wird.

## Claims

1. Method for hydrophilic bonding of a first substrate (S1) to a second substrate (S2), comprising:
- bringing the first substrate (S1) and the second substrate (S2) into contact so as to form a bonding interface (I) between a main surface of the first substrate and a main surface of the second substrate,
- applying a heat treatment adapted to close said bonding interface,
said method being **characterized in that** it comprises, before the bringing into contact step, depositing, on the main surface of the first and/or second substrate, a bonding layer (12, 22) of a non-metallic material permeable to dihydrogen and having, at the temperature of the heat treatment, an elastic limit lower than that of at least one of the materials of the first substrate (S1) and of the second substrate (S2) located at the bonding interface, the said layer having a thickness of between 1 and 6 nm, and **in that** the heat treatment is carried out at a temperature of less than or equal to 900°C, preferably less than or equal to 600°C.

2. Method according to claim 1, wherein the first substrate (S1) comprises a surface layer (11) of silicon oxide other than native oxide, and the bonding layer is deposited on said silicon oxide layer.

3. Method according to claim 2, wherein the silicon oxide surface layer is formed by thermal oxidation of the first substrate (S1).

4. Method according to any of claims 2 or 3, wherein the second substrate (S2) comprises a surface layer (21) of silicon oxide other than native oxide, and a bonding layer is also deposited on said silicon oxide layer.

5. Method according to any of claims 1 to 4, comprising, after application of the heat treatment for closing the bonding interface, a step of thinning the first substrate so as to transfer a thin layer of the first substrate onto the second substrate.

6. Method according to claim 5, further comprising, between depositing the bonding layer and contacting the first substrate and the second substrate, forming a surface layer of silicon oxide on the first substrate and implanting ionic species into the first substrate through the silicon oxide layer so as to form an embrittlement zone bounding the semiconductor layer to be transferred.

7. Method according to any one of claims 1 to 6, comprising, between the deposition of the bonding layer and the contacting of the first and second substrates, performing a hydrophilic treatment of the main surface of said substrates, applying water to the main surface of said substrates to form a water film on said major surface.

8. Method according to any one of claims 1 to 7, comprising, prior to the deposition of the bonding layer, a step of cleaning the main surface on which said layer is to be deposited by an oxidizing solution.

9. Method according to any of claims 1 to 8, wherein the second substrate (S2) is a silicon substrate, said substrate being covered with a layer (20b) of native silicon oxide.

10. Method according to claim 9, comprising, during implementation of the bonding interface closure heat treatment, oxidizing a surface portion of the silicon of the second substrate through the native oxide layer.

11. Method according to any of claims 1 to 10, wherein the material of the bonding layer (12, 22) is selected from: amorphous silicon and amorphous germanium.

12. Method according to claim 11, wherein the bonding layer material is amorphous silicon and the amorphous silicon layer is formed in an epitaxy chamber at a temperature below 550°C.

13. Method according to claim 12, wherein the amorphous silicon layer is formed from a precursor selected from: disilane (Si₂ H₆ ), silane (SiH₄ ) or a liquid precursor of the formula Siₙ H₂ₙ₊₂ where n is an integer greater than 2.

14. Method according to any of claims 11 to 13, comprising, during the implementation of the heat treatment for closing the bonding interface, oxidizing at least a portion (12b) of the bonding layer (12).

15. Method according to claim 14, wherein the thickness of the bonding layer (12) is selected so that the entirety of said layer is oxidized during the heat treatment to close the bonding interface.
